# EUROPEAN PATENT APPLICATION

(11) **EP 2 192 691 A1**
(43) Date of publication of application: **02.06.2010**
(21) Application number: 09156711.5
(22) Date of filing: 30.03.2009
(51) Int. Cl.: H03M 7/30, H04N 7/26

(54) **Image recording apparatus and method of recording image**

(30) Priority: 27.11.2008 KR 20080119000
(71) Applicant: Samsung Electronics Co., Ltd., Suwon-si, Gyeonggi-do 442-742 (KR)
(72) Inventor: Kim, Da-Rae, Suwon-si (KR)
(74) Representative: Waddington, Richard

(57) **Abstract**

There are provided an image recording apparatus and an image recording method. The image recording apparatus includes: a display unit which displays a selectable compression mode (S302); a user input unit through which the compression mode selected by a user (S303) is inputted; a recording unit in which an image is recorded; an encoding unit which compresses the image (S304); and a controlling unit which controls the display unit to display the selectable compression mode and controls the encoding unit to compress the image according to the input compression mode for record in the recording unit.

## Description

### BACKGROUND OF INVENTION

### Field of Invention

Apparatuses and methods consistent with the present invention relate to an image recording apparatus and an image recording method which can highly compress an image signal for record in a digital image recording/reproducing apparatus, thereby efficiently utilizing a recording space.

### Description of Related Art

In an image signal recording/reproducing apparatus such as a personal video recorder (PVR), when a DTV (Digital Television) image signal is inputted, an MPEG (Moving Picture Experts Group) image signal of an input transport stream (TS) is recorded on a recording medium such as an HDD without any image processing; and when an analog signal is inputted, the input signal is converted into an MPEG signal through MPEG encoding and then recorded in the recording medium. In such a system, the recording medium has a limited capacity. Further, a high definition image signal requires a large capacity, and thus, recording may be affected by the capacity of the recording medium. Thus, for example, in the case that the data amount of a program to be recorded is larger than a remaining capacity of the recording medium, a previously recorded program should be deleted.

### SUMMARY OF INVENTION

Accordingly, it is an aspect of the present invention to provide an image recording apparatus and an image recording method which can compress an image at a desired compression rate for record and reduce the capacity of the image recorded on a recording medium through a high-compression encoding process, thereby effectively utilizing a recording space.

Additional aspects of the present invention will be set forth in part in the description which follows and, in part, will be obvious from the description, or may be learned by practice of the present invention.

According to the present invention there is provided an apparatus and method as set forth in the appended claims. Other features of the invention will be apparent from the dependent claims, and the description which follows.

According to an aspect of the invention an image recording apparatus including: a display unit which displays a selectable compression mode; a user input unit through which the compression mode selected by a user is inputted; a recording unit in which an image is recorded; an encoding unit which compresses the image; and a controlling unit which controls the display unit to display the selectable compression mode and controls the encoding unit to compress the image according to the input compression mode for record in the recording unit.

The controlling unit may compare the capacity of the image to be compressed in each compression mode with a remaining capacity of the recording unit and controls the display unit to display the selectable compression mode.

The controlling unit may control the encoding unit to vary the length of a GOP to compress the image.

The controlling unit may control the encoding unit to increase the length of the GOP in each compression mode and to substitute I-pictures except a first I-picture with P-pictures to compress the image.

The controlling unit may control the encoding unit to increase the number of B-pictures existing between an I-picture and an adjacent P-picture and between adjacent P-pictures as many as integer times to compress the image.

The controlling unit may control the encoding unit to increase the length of the GOP according to each compression mode, to substitute I-pictures except a first I-picture with P-pictures, and to substitute intermediate P-pictures with B-pictures while maintaining the number of the whole P-pictures the same as the number of the P-pictures in the GO P in a default mode, for image compression.

The controlling unit may control the encoding unit to vary the rate of at least one of B-pictures or/and P-pictures forming a GOP to compress the image.

The controlling unit may control the encoding unit to substitute at least one of the P-pictures with the B-picture to compress image.

The controlling unit may control the display unit to display the selectable compression modes in order according to at least one of compression rate, image quality and capacity.

The foregoing and/or other aspects of the present invention can be achieved by providing an image recording method including: displaying a selectable compression mode;

receiving the compression mode selected by a user; and compressing an image according to the received compression mode for record.

The length of a GOP may be varied to compress the image.

The length of the GOP may be increased as many as integer times according to each compression mode, and I-pictures except a first I-picture is substituted with P-pictures, to compress the image.

The number of B-pictures existing between an I-picture and an adjacent P-picture and between adjacent P-pictures may be increased as many as integer times according to each compression mode, to compress the image.

The length of the GOP may be increased as many as integer times, I-pictures except a first I-picture are substituted with P-pictures, and intermediate P-pictures be substituted with B-pictures while maintaining the number of the whole P-pictures the same as the number of P-pictures in the GOP in a default mode, according to each compression mode, to compress the image.

The rate of at least one of B-pictures or/and P-pictures forming a GOP may be varied to compress the image.

According to the present invention, there is provided an image recording apparatus and an image recording method which can compress an image at a desired compression rate for record and reduce the capacity of the image recorded in the recording medium through a high-compression encoding process, thereby effectively utilizing a recording space.

### BRIEF DESCRIPTION OF DRAWINGS

The above and/or other aspects of the present invention will become apparent and more readily appreciated from the following description of the exemplary embodiments, taken in conjunction with the accompanying drawings, in which:
FIG. 1 is a block diagram illustrating an image recording apparatus according to an exemplary embodiment of the present invention;
FIG. 2A illustrates a configuration of a general GOP (Group Of Picture);
FIG. 2B illustrates an example of a GOP compressed by an image recording method according to an exemplary embodiment of the present invention;
FIG. 2C illustrates an example of a GOP compressed by an image recording method according to another exemplary embodiment of the present invention;
FIG. 2D illustrates an example of a GOP compressed by an image recording method according to still another exemplary embodiment of the present invention;
FIG. 2E illustrates an example of a GOP compressed by an image recording method according to yet still another exemplary embodiment of the present invention; and
FIG. 3 is a flowchart illustrating an image recording process according to an exemplary embodiment of the present invention.

### DETAILED DESCRIPTION OF EXEMPLARY EMBODIMENTS

Reference will now be made in detail to the embodiments of the present invention, examples of which are illustrated in the accompanying drawings, wherein like reference numerals refer to like elements throughout. The exemplary embodiments are described below so as to explain the present invention by referring to the figures. Redundant description to different embodiments may be omitted as necessary.

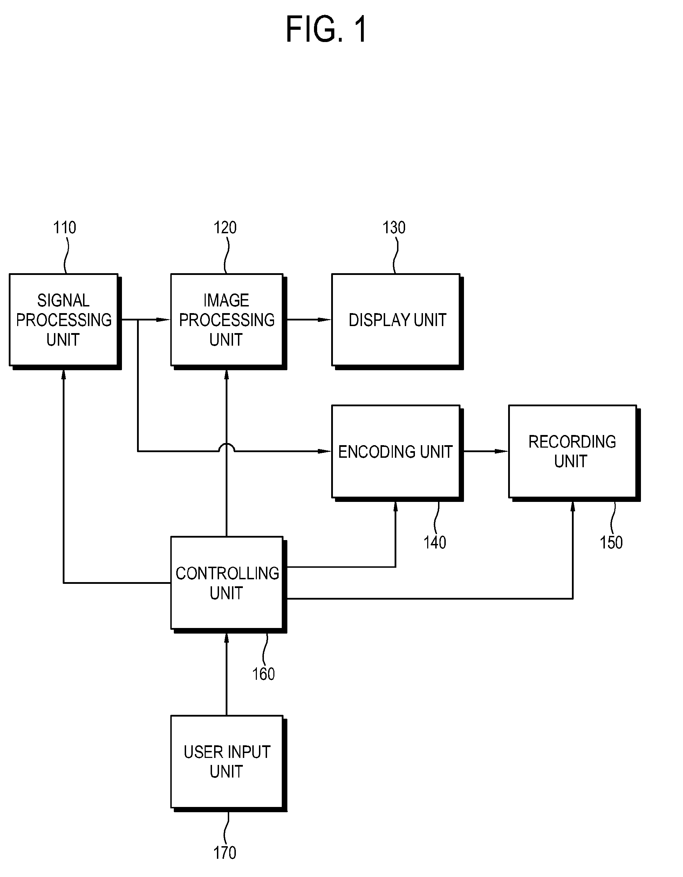

FIG. 1 is a block diagram illustrating an image recording apparatus 10 0 according to an exemplary embodiment of the present invention.

The image recording apparatus 100 may include a personal video recorder (PVR) such as a digital video recorder (DVR); a digital TV; a desktop computer; a laptop computer; a mobile terminal or a personal digital assistant (PDA). Further, the image recording apparatus 100 may include any electronic device for compressing an image according to an MPEG standard for record.

The image recording apparatus 100 may include a signal processing unit 110; an image processing unit 120; a display unit 130; an encoding unit 140; a recording unit 150; a controlling unit 160; and a user input unit 170.

The signal processing unit 110 processes an input image signal. More specifically, the signal processing unit 110 demodulates and decompresses the image signal. To this end, the signal processing unit 110 may include a demodulator and a decoder.

The image processing unit 120 processes an image and outputs th e image to th e display unit 130. More specifically, the image processing unit 120 scales the image to be suitable for a screen or adjusts the brightness of the image. Further, the image processing unit 120 may generate an on screen display (OSD) signal.

The display unit 130 may display a selectable compression mode. Also, the display unit 130 may display the selectable compression mode as an OSD. In this respect, the compression mode may be classified according to a variable size of a group of picture (GOP) or a variable rate of a predictive-picture (P-picture) or/and a bidirectional predictive-picture (B-picture) for forming the GOP. Further, the display unit 130 may arrange the selectable compression modes in order based on at least one of a compression rate, image quality and capacity. For example, the display unit 130 may sequentially arrange the compression modes which user can select from a low compression mode to a high compression mode.

The encoding unit 140 applies a different compression rate according to each compression mode to compress the image. Then, the encoding unit 140 may record the compressed image in the recording unit 150.

In the recording unit 150 is recorded the image. The recording unit 150 may include a hard disk drive (HDD) or the like.

The controlling unit 160 may control the encoding unit 140 to compress the image according to an input compression mode and to record the image in the recording unit 150.

More specifically, the controlling unit 160 may control the encoding unit 140 to vary a rate of at least one of the B-picture or/and the P-picture for forming the GOP for image compression. In this case, the controlling unit 160 may control the encoding unit 140 to substitute at least one P-picture for forming the GOP with the B-picture for image compression.

Also, the controlling unit 160 may control the encoding unit 140 to vary the size of the GOP for image compression. In this case, the controlling unit 160 may control the encoding unit 140 to substitute intra-pictures (I-picture) except a first I-picture with the P-picture for image compression when the size of the GOP is enlarged with integer times according to each compression mode.

Further, according to another exemplary embodiment, the controlling unit 160 may control the encoding unit 140 to increase the number of the B-picture existing between the I-picture and the adjacent P-picture and the adjacent P-pictures as many as integer times according to the respective compression modes, for image compression.

Furthermore, according to still another exemplary embodiment, the controlling unit 160 may control the encoding unit 140 to increase the size of th e GOP according to each compression mode, to substitute I-pictures except the first I-picture with the P-picture, and to substitute the intermediate P-pictures with the B-pictures while maintaining the number of the whole P-pictures the same as the number of the P-pictures in the GOP in the default mode, for image compression.

The controlling unit 160 may control the display unit 130 to display the selectable compression mode. In the respect, the controlling unit 160 may compare the capacity of th e image to be compressed according to each compression mode with a remaining capacity of the recording unit 150 to control the display unit 130 to display the selectable compression mode. Further, the controlling unit 160 may control the display unit 130 to sequentially arrange the selectable compression modes based on at least one of a compression rate, image quality and capacity.

Through the user input unit 170 is inputted the compression mode selected by a user.

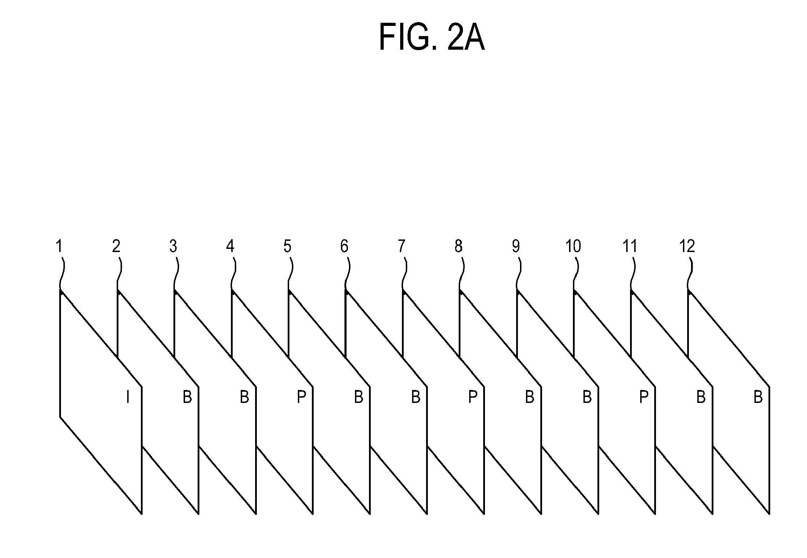

FIG. 2A illustrates a configuration of a general GOP.

According to the MPEG standard, the image is encoded in a unit of the GOP during compression. The GOP is formed of I-pictures, P-pictures and B-pictures; and one GOP is formed of one I-picture and the P-pictures and B-pictures coming before the following I-picture. In this case, the I-picture serves as a starting point of each GOP.

The size of the GOP is variable but generally includes 12 or 15 pictures. For example, the GOP in FIG. 2A includes 12 pictures.

The I-picture removes only spatial redundancy and does not remove temporal redundancy. Accordingly, the I-picture serves as an independent frame regardless of the other frames and becomes a reference picture of the other pictures. The I-picture is relatively good in image quality, but has large capacity.

The P-picture removes the temporal redundancy using forward prediction. That is, the P-picture is a picture that is encoded using a motion estimation technique on the basis of the latest I-picture or P-picture.

Th e B-picture removes temporal redundancy simultaneously using forward prediction and backward prediction. That is, the B-picture is a picture predicted on the basis of the pre-coming and post-coming I-picture or P-picture. The B-picture is relatively poor in image quality compared with the other pictures, but has small capacity. The data amount is in the order of I-picture> P-picture > B-picture.

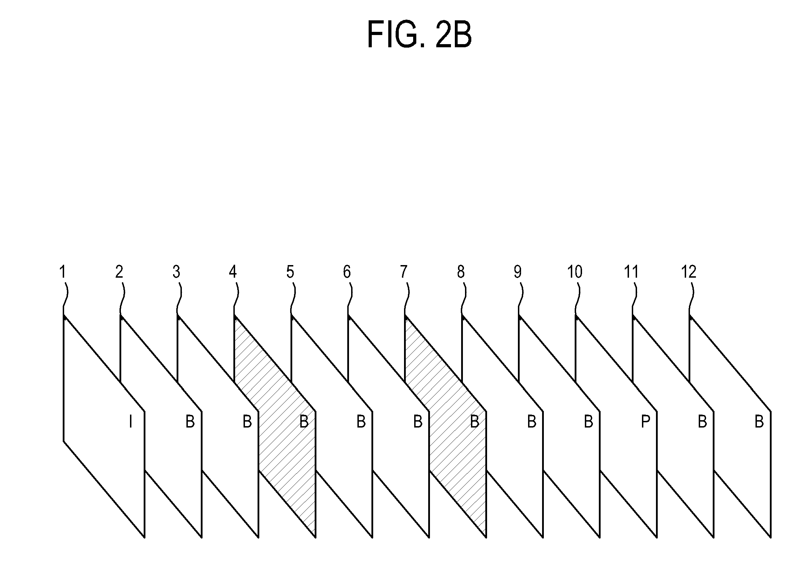

Hereinafter, image recording methods according to various exemplary embodiments of the present invention will be described in more detail with reference to FIGS. 2B to 2E. In FIGS. 2B to 2E, it is assumed that image compression according to the GOP shown in FIG. 2A is referred to as a default mode.

FIG. 2B illustrates an example of a GOP compressed by an image recording method according to an exemplary embodiment of the present invention.

According to th e present embodiment, the image recording apparatus 100 may control the encoding unit 140 to substitute at least one P-picture for forming the GOP with the B-picture for image compression.

More specifically, the number of the P-pictures substituted with the B-pictures may be increased according to the respective compression modes in such a manner that one P-picture is substituted with the B-picture in the first compression mode and two P-pictures are substituted with the B-picture in the second compression mode.

FIG. 2B illustrates an example that two P-pictures, that is, the fourth and seventh P-pictures are substituted with the B-pictures for image compression.

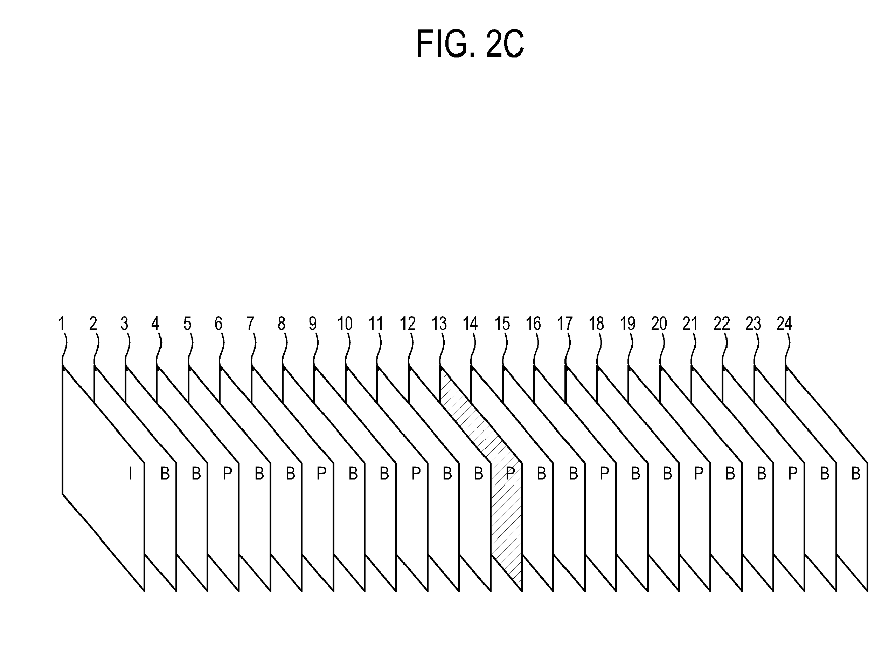

FIG. 2C illustrates an example of a GOP compressed by an image recording method according to another exemplary embodiment of the present invention.

According to th e present embodiment, th e image recording apparatus 100 may control the encoding unit 140 to increase the size of the GOP as many as integer times according to the respective compression modes and to substitute I-pictures except the first I-picture with the P-pictures for image compression.

As the size of the GOP is large and the ratio of the B-picture in the GOP is high, the compression rate is high. Accordingly, according to the present embodiment, the number of the I-pictures is decreased and the number of the B-pictures is increased to decrease the data amount of an image to be compressed. To this end, the size of the GOP is increased as many as integer times according to the respective compression modes. Further, considering that one I-picture may exist in the unit of the GOP, the I-pictures except the first I-picture is substituted with the P-pictures for image compression.

More specifically, the length of the GOP may be increased as many as integer times according to the respective compression modes in such a manner that the length of the GOP may be increased as many as two times of the default mode in the first compression mode; and the length of the GOP may be increased as many as three times of the default mode in the second compression mode. In this case, since the default mode is formed of 12 pictures, the GOP is formed of 24 pictures in the first compression mode; and the GOP is formed of 36 pictures in the second compression mode. Further, the 13th I-picture is substituted with the P-picture for image compression in the first compression mode; and the 13th I-picture and the 25th I-picture are respectively substituted with the P-pictures for image compression in the second compression mode. In this case, the GOP stored in the first compression mode becomes IBBPBBPBBPBBPBBPBBPBBPBB; and the GOP stored in the second compression mode becomes IBBPBBPBBPBBPBBPBBPBBPBBPBBPBBPBBPBB. The GOP shown in FIG. 2C is IBBPBBPBBPBBPBBPBBPBBPBB, and thus, represents the GOP stored in the first compression mode.

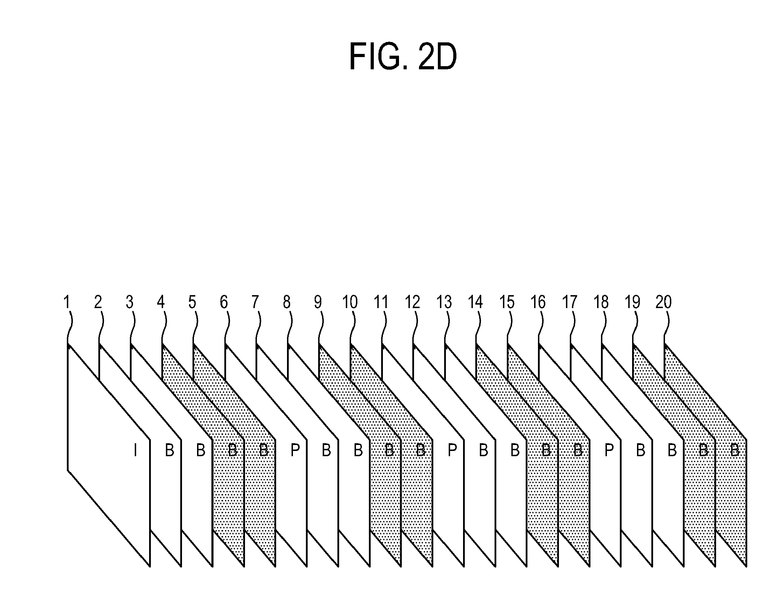

FIG. 2D illustrates an example of a GOP compressed according to still another exemplary embodiment of the present invention.

According to the present embodiment, the image recording apparatus 100 may control the encoding unit 140 to increase the number of the B-pictures existing between the I-picture and the adjacent P-picture and between the adjacent P-pictures as many as integer times for image compression. In the present embodiment, the number of the I-picture and the P-pictures is not increased, but only the number of the B-pictures is increased. In this case, the size of the GOP is increased. Further, as the rate of the B-pictures in the GOP becomes high, the compression rate becomes high.

Generally, in the case of the GOP having a default size of 12, the number of the B-pictures existing between the I-picture and the adjacent P-picture and between the adjacent two P-pictures is two. Accordingly, the encoding unit 140 performs encoding in such a manner that in the first compression mode, the number of the B-pictures between the I-picture and the P-picture and the adjacent two P-pictures is increased into four, and in the second compression mode, the number of the B-pictures between the I-picture and the adjacent P-picture and the adjacent two P-pictures is increased into six.

In this case, the GOP stored in the first compression mode becomes IBBBBPBBBBPBBBBPBBBB; and the GOP stored in the second compression mode becomes IBBBBBBPBBBBBBPBBBBBB. T h e GO P shown in FIG. 2D is formed of IBBBBPBBBBPBBBBPBBBB, and thus, represents the GOP stored in the first compression mode.

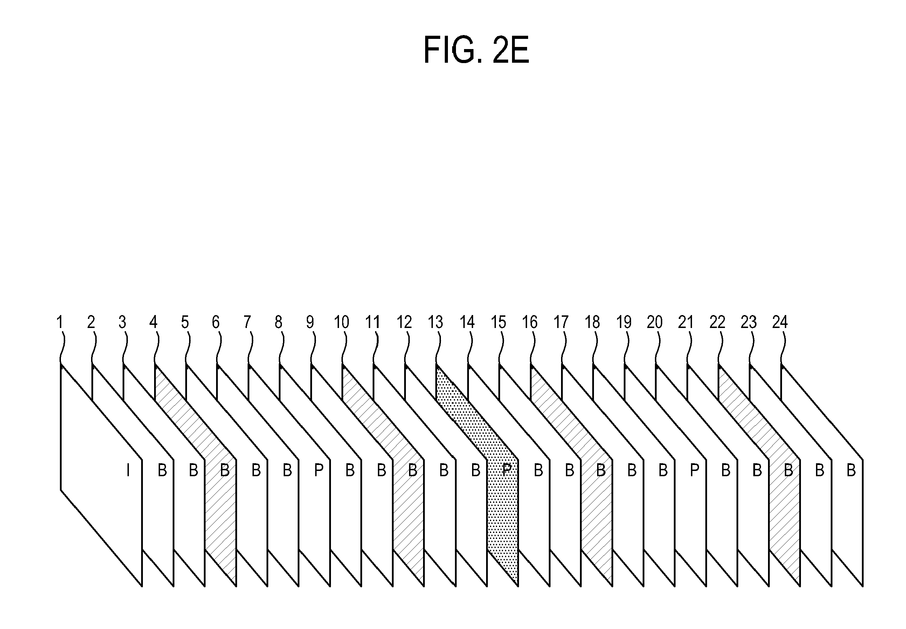

FIG. 2E illustrates an example a GOP compressed by an image recording method according to yet another exemplary embodiment of the present invention.

According to th e present embodiment, the image recording apparatus 100 may control the encoding unit 140 to increase the size of the GOP according to each compression mode, to substitute the I-pictures except the first I-picture with the P-picture, and to substitute the intermediate P-pictures with the B-pictures while maintaining the number of the whole P-pictures the same as the number of the P-pictures in the GOP in the default mode, for image compression.

This fourth exemplary embodiment corresponds to the combination of the above-described second and third exemplary embodiments. That is, the size of the GOP is increased as many as integer times, and simultaneously, the number of the B-pictures existing between the I-picture and the adjacent P-picture and the adjacent two P-pictures is increased as many as integer times.

More specifically, in the first compression mode, the length of the GOP is increased as many as two times and the number of the B-pictures existing between the I-picture and the adjacent P-picture and the adjacent two P-pictures is increased as many as two times; and in the second compression mode, the length of the GOP is increased as many as three times and the number of the B-pictures existing between the I-picture and the adjacent P-picture and the adjacent two P-pictures is increased as many as three times.

In this case, the GOP stored in the first compression mode becomes IBBBBBPBBBBBPBBBBBPBBBBB; and the GOP in the second compression mode becomes IBBBBBBBBPBBBBBBBBPBBBBBBBBPBBBBBBBB. The GOP shown in FIG. 2E is formed of IBBBBBPBBBBBPBBBBBPBBBBB, and thus, represents the GOP stored in the first compression mode.

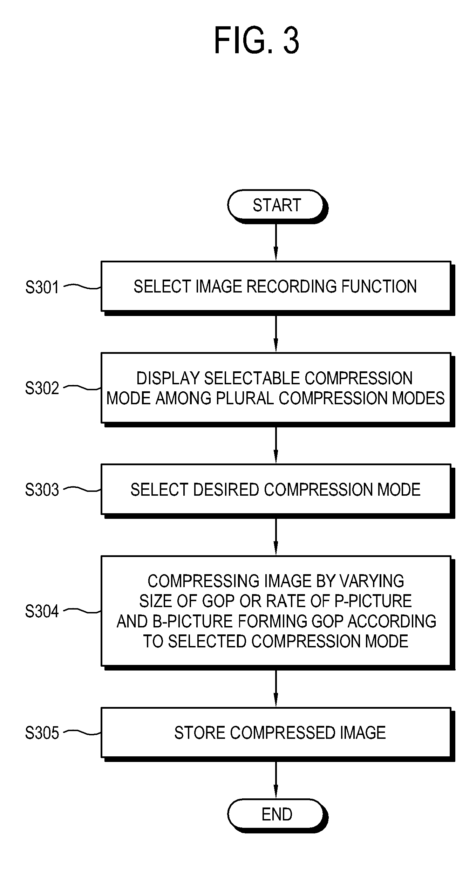

FIG. 3 is a flowchart illustrating an image recording process according to an exemplary embodiment of the present invention.

Firstly, a user selects an image recording function to record an image (S301).

The image recording apparatus 100 displays selectable compression modes among a plurality of compression modes (model, mode2, ....., and modeN) (S302). In this respect, the image recording apparatus 100 may compare the capacity of an image to be compressed in each compression modes with a remaining capacity of the recording unit to display the selectable compression modes.

The plurality of compression modes is different from each other in compression rate. Generally, the higher the compression rate is, the lower the image quality becomes. Thus, according to the present invention, the user may select one compression mode among the selectable compression modes in consideration of the relationship between the compression rate, capacity and image quality.

To this end, the image recording apparatus 100 may arrange the selectable compression modes in order according to at least one of the compression rate, capacity and image quality. For example, the image recording apparatus 100 may sequentially arrange the selectable compression modes from a compression mode having a low compression rate to a compression mode having a high compression rate.

According to another embodiment of the present invention, in the case that the data amount of an image to be recorded is larger than the remaining capacity, the selectable compression modes among the plurality of compression modes may be displayed.

According to still another embodiment of the present invention, in the case that a user directly compresses a program to be recorded or a program previously recorded to select a menu to be recorded, the selectable compression modes among the plurality of compression modes may be displayed. In this case, the user may re-encode data previously recorded to decrease the capacity of data previously recorded for management of the recording medium.

According to yet another embodiment of the present invention, in the case that a digital signal is inputted, the selectable compression modes among the plurality of compression modes may be displayed. In most of current PVR systems, in the case that an analog signal is inputted, an MPEG compression process is necessarily required for record in a recording medium in the MPEG TS (Transport Stream) standard. However, in the case that a digital signal is inputted, the record is performed without passing the MPEG encoder. Accordingly, in the present embodiment, in the case that a digital signal is inputted, a signal path may be additionally connected to the encoding unit fo r application of high-compression encoding. In this respect, since most of encoding units has an input format of BT 601/656 which is a digital component interface standard, a digital image signal may be converted to be suitable for an input format of the encoding unit through a format converter and then inputted to the encoding unit.

The user selects a desired compression mode among the displayed compression modes (S303).

The image recording apparatus 100 varies the size of the GOP or the rate of the P-pictures and the B-pictures forming the GOP according to the selected compression mode for image compression (S304). Then, the compressed image is recorded (S305), thereby completing the entire image recording process.

Although a few exemplary embodiments of the present invention have been shown and described, it will be appreciated by those skilled in the art that changes may be made in these embodiments without departing from the principles of the invention, the scope of which is defined in the appended claims and their equivalents.

Attention is directed to all papers and documents which are filed concurrently with or previous to this specification in connection with this application and which are open to public inspection with this specification, and the contents of all such papers and documents are incorporated herein by reference.

All of th e features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in th i s specification (including any accompanying claims, abstract and drawings), or to any novel one, or any novel combination, of the steps of any method or process so disclosed.

## Claims

1. An image recording apparatus comprising:
a display unit (130) which displays a selectable compression mode;
a user input unit (170) through which the compression mode selected by a user is inputted;
a recording unit (150) in which an image is recorded;
an encoding unit (140) which compresses the image; and
a controlling unit (160) which controls the display unit (130) to display the selectable compression mode and controls the encoding unit (140) to compress the image according to the input compression mode for record in the recording unit (150).

2. The apparatus according to claim 1, wherein the controlling unit (160) compares the capacity of the image to be compressed in each compression mode with a remaining capacity of the recording unit (150) and controls the display unit (130) to display the selectable compression mode.

3. The apparatus according to claim 1, wherein the controlling unit (160) controls the encoding unit (140) to vary the length of a GOP to compress the image.

4. The apparatus according to claim 3, wherein the controlling unit (160) controls the encoding unit (140) to increase the length of the GOP in each compression mode and to substitute I-pictures except a first I-picture with P-pictures to compress the image.

5. The apparatus according to claim 3, wherein the controlling unit (160) controls the encoding unit (140) to increase the number of B-pictures existing between an I-picture and an adjacent P-picture and between adjacent P-pictures as many as integer times to compress the image.

6. The apparatus according to claim 3, wherein the controlling unit (160) controls the encoding unit (140) to increase the length of the GOP according to each compression mode, to substitute I-pictures except a first I-picture with P-pictures, and to substitute intermediate P-pictures with B-pictures while maintaining the number of the whole P-pictures the same as the number of the P-pictures in the GOP in a default mode, for image compression.

7. The apparatus according to claim 1, wherein the controlling unit (160) controls the encoding unit (140) to vary the rate of at least one of B-pictures or/and P-pictures forming a GOP to compress the image.

8. The apparatus according to claim 7, wherein the controlling unit (160) controls the encoding unit (140) to substitute at least one of the P-pictures with the B-picture to compress image.

9. The apparatus according to any preceding claim, wherein the controlling unit (160) controls the display unit (130) to display the selectable compression modes in order according to at least one of compression rate, image quality and capacity.

10. An image recording method comprising:
displaying a selectable compression mode;
receiving the compression mode selected by a user; and
compressing an image according to the received compression mode for record.

11. The method according to claim 10, wherein the length of a GOP is varied to compress the image.

12. The method according to claim 11, wherein the length of the GOP is increased as many as integer times according to each compression mode, and I-pictures except a first I-picture is substituted with P-pictures, to compress the image.

13. The method according to claim 11, wherein the number of B-pictures existing between an I-picture and an adjacent P-picture and between adjacent P-pictures is increased as many as integer times according to each compression mode, to compress the image.

14. The method according to claim 11, wherein the length of the GOP is increased as many as integer times, I-pictures except a first I-picture are substituted with P-pictures, and intermediate P-pictures are substituted with B-pictures while maintaining the number of the whole P-pictures the same as the number of P-pictures in the GOP in a default mode, according to each compression mode, to compress the image.

15. The method according to any one of claims 10 to 14, wherein the rate of at least one of B-pictures or/and P-pictures forming a GOP is varied to compress the image.
